(19) Europäisches Patentamt
European Patent Office
Office européen des brevets

(11) **EP 2 506 024 B1**

(12) **EUROPEAN PATENT SPECIFICATION**

(45) Date of publication and mention
of the grant of the patent:
**21.08.2013 Bulletin 2013/34**

(51) Int Cl.:
***G01R 31/36*** *(2006.01)*     ***H01M 10/42*** *(2006.01)*

(21) Application number: **11002742.2**

(22) Date of filing: **01.04.2011**

(54) **Battery tester for cold cranking amperes test**

Batterietestgerät für Kaltstartstromtest

Testeur de batterie pour essai de courant de démarrage à froid

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.10.2012 Bulletin 2012/40**

(73) Proprietor: **DHC Specialty Corp.**
**Taipei (TW)**

(72) Inventors:
 • **Sheng, Hsien-Fang**
**Nei Hu Dist.**
**Taipei (TW)**

 • **Hsiao, Yuan-Chen**
**Nei Hu Dist.**
**Taipei (TW)**

(74) Representative: **Hauck Patent- und Rechtsanwälte**
**Neuer Wall 50**
**20354 Hamburg (DE)**

(56) References cited:
**US-A- 4 707 795     US-A- 5 773 977**
**US-A1- 2006 244 423     US-A1- 2009 237 086**
**US-B1- 6 259 254     US-B1- 6 369 577**

**Description**

1. Field of the Invention

The present invention relates to the field of a battery tester, and more particularly to a battery tester providing high precision detecting results.

2. Description of Related Art

There are many types of the rechargeable battery with different capacities on the market. The battery tester is used to detect the residual capacity of the rechargeable battery to determine the health of the rechargeable battery. However, the conventional battery tester uses only one method to detect different rechargeable batteries and inaccurate testing result will likely occur.

In general, the conventional battery tester uses 1/2Cold Cranking Amps (hereinafter CCA) testing method to detect the health of the rechargeable battery, the method having steps of: (a) adding a load to the two electrodes of the battery to discharge the battery by loading the amperes of 1/2CCA for 15 seconds; and (b) determining the health of the battery according to the discharging diagram.

In the conventional testing method implemented by the battery tester, the resistance of the load and the duration of adding load to the battery are fixed. Therefore, when the battery tester respectively detects rechargeable batteries with different capacities, figures of the discharging diagrams are not precise. The testing precision of the conventional battery tester is not ideal for all rechargeable batteries. Other similar battery testers may be referred to US 2006/244423 A1, US 6369577 B1, US 4707795 B1, US 2009/237086 A1, and US 5773977 A.

With reference to US 6259254 B1, an apparatus and method for carrying out diagnostic tests on batteries is disclosed.

To overcome the shortcomings, the present invention provides a battery tester with high precision to mitigate or obviate the aforementioned problems.

Based on the foregoing drawbacks of the conventional battery tester, the main objective of the present invention is to provide a battery tester as defined in claim 1.

The battery tester has a casing having an input device and two detecting wires, a microprocessor, a variable loading unit and a battery power status detecting unit. The microprocessor stores a strategic decision process therein to determine a proper resistance of a load for a battery according to the cold cranking amperes $CCA_B$, the battery voltage and detection requirements including a 1/N CCA inputted from the input device. When the resistance of the load is determined, the microprocessor adjusts a resistance of the variable loading unit in accordance with the calculated loading resistance. The microprocessor further executes a detecting process to obtain a detecting waveform to determine the battery status. Therefore, the battery tester does not use the load with a fixed resistance to detect batteries with different capacities and has accurate detecting results.

Other objectives, advantages and novel features of the invention will become more apparent from the following detailed description when taken in conjunction with the accompanying drawings.

IN THE DRAWINGS

Fig. 1 is a perspective view of a battery tester in accordance with the present invention;
Fig. 2 is a functional block diagram of a first embodiment of a battery tester in accordance with the present invention;
Fig. 3 is a flow chart of a strategic decision process in testing mode implemented in Fig. 1;
Fig. 5A is a circuit diagram of a first embodiment of a variable load unit of the battery tester in accordance with the present invention;
Fig. 5B is a circuit diagram of a second embodiment of a variable load unit of the battery tester in accordance with the present invention;
Fig. 5C is a circuit diagram of a third embodiment of a variable load unit of the battery tester in accordance with the present invention;

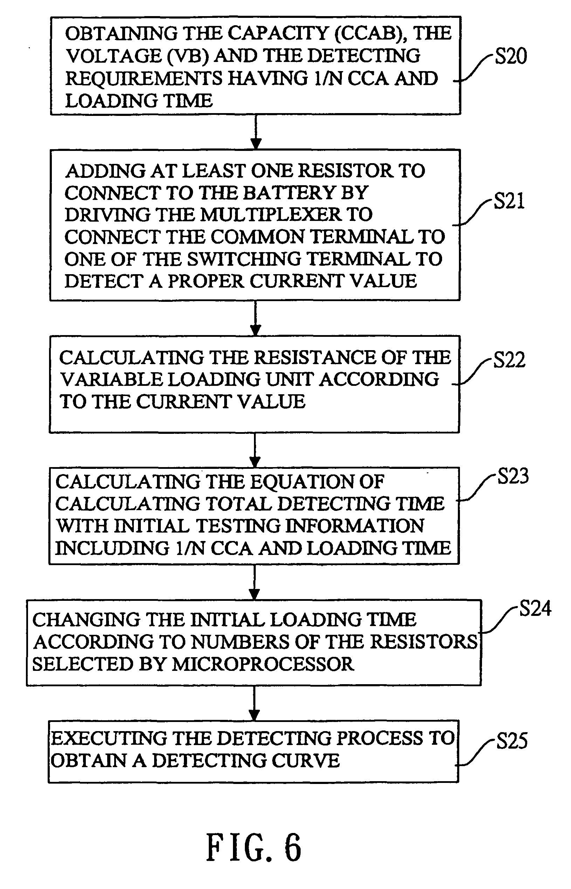

Fig. 6 is a flow chart of a strategic decision process in a first detecting mode implemented in Figs. 5A, 5B and 5C in accordance with the present invention;
Fig. 7 is a testing diagram of the battery tester in accordance with the present invention; and
Fig. 8 is a flow chart of a detecting process in accordance with the present invention.

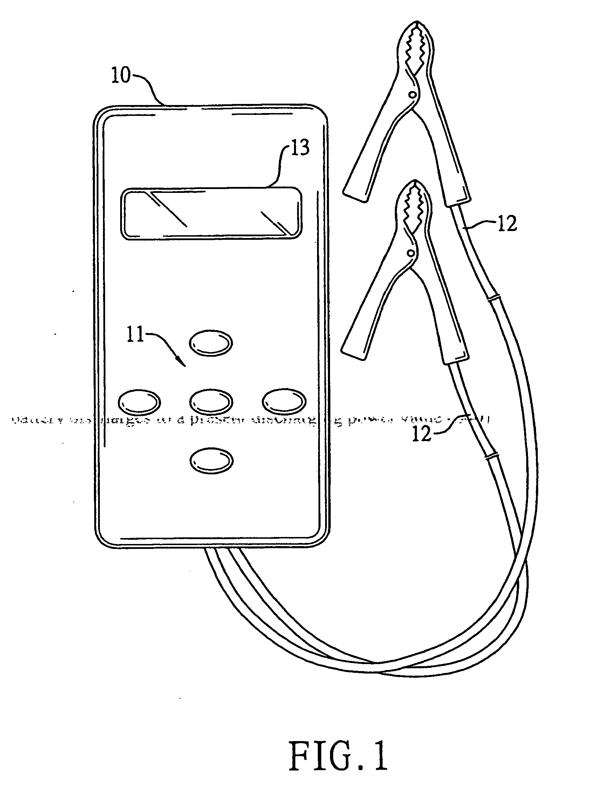

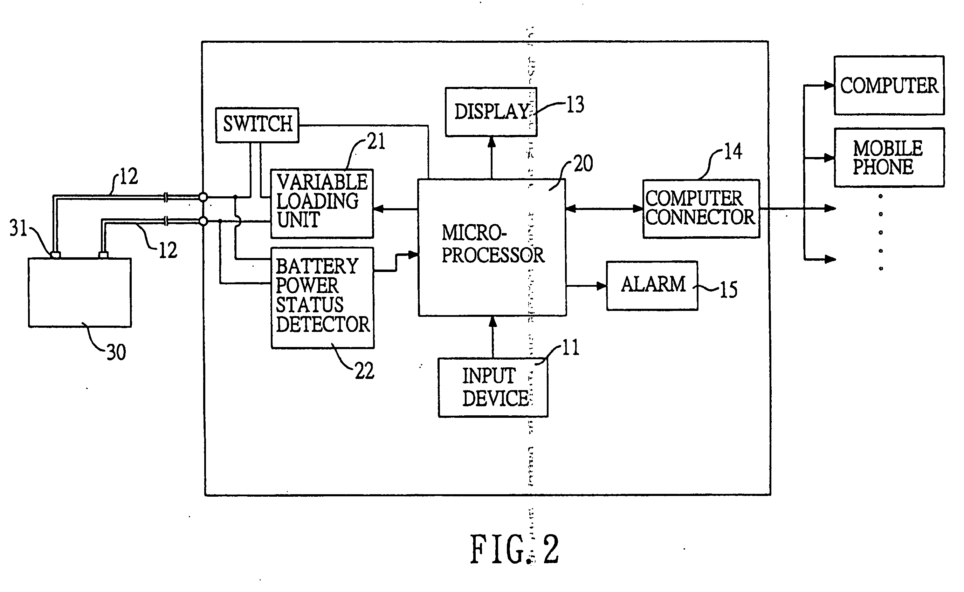

With reference to Figs. 1 and 2, a first embodiment of a battery tester in accordance with the present invention has a casing 10, a microprocessor 20, a variable loading unit 21 and a battery power status detecting unit 22.

The casing 10 has an input device 11 and two detecting wires 12. A user uses the input device 11 to select a specific battery capacity. The detecting wires 12 are respectively and electronically connected to two electrodes 31 of the battery 30. In the first embodiment, the two detecting wires 12 respectively clip to the two electrodes 31 of the battery 30. In addition, the casing 10 further has a display 13, a computer connector 14 and an alarm 15. The computer connector 14 is used to connect to an external electronic device such as a computer or mobile phone.

The microprocessor 20 stores a strategic decision process and a detecting process therein.

The variable load unit 21 is electronically connected to the microprocessor 20 and the electrodes 31 of the battery 30 to detect voltage and current changes of the battery 30 and then responds with the voltage and current values to the microprocessor 20.

The battery power status detecting unit 22 is connected between the detecting wires 12 and the microprocessor 20 to detect the battery voltage value and/or current value. Further, the battery power status detecting unit 22 may be built-in the microprocessor 20.

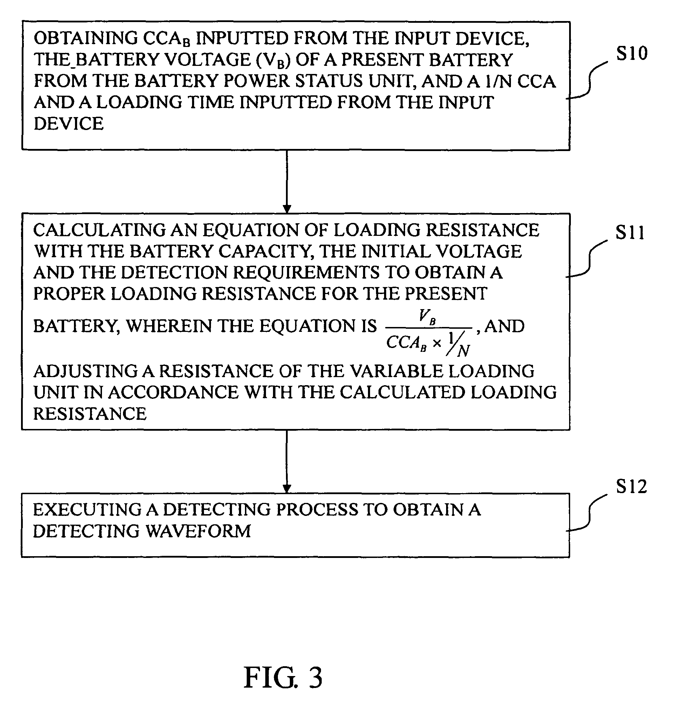

With further reference to Fig. 3, the microprocessor 20 executes the strategic decision process having the following steps of:

(a) obtaining - cold cranking amperes $CCA_B$ inputted from the input device 11, the battery voltage ($V_B$) of a present battery 30 from the battery power status unit 22, and a detection requirement including a 1/N CCA inputted from the input device 11 (S10);
(b) calculating an equation of loading resistance with the battery capacity, the initial voltage and the detection requirements to obtain a proper loading resistance for the present battery 30 (S11), wherein

the equation is $\dfrac{V_B}{CCA_B \times \dfrac{1}{N}}$, and adjusting a

resistance of the variable loading unit 21 in accordance with the calculated loading resistance; and
(c) executing a detecting process to obtain a detecting waveform (S12).

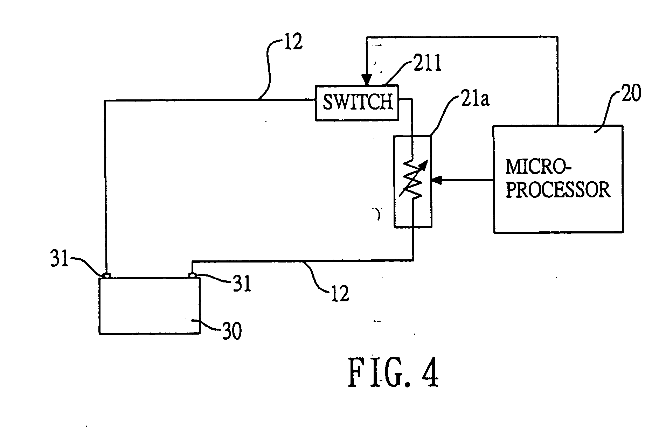

With reference to Fig. 4, the variable loading unit 21 has a variable resistor 21 a and a switch 211. The variable resistor 21 a is electronically connected to the detecting wires 12. The variable resistor 21a is electronically connected to the microprocessor 20. The switch 211 is electronically connected between one of the detecting wire 12 and the corresponding end of the variable resistor 21a. The microprocessor 20 adjusts resistance of the variable resistor 21a. The microprocessor 20 further controls the switch 211 to be turned on or off.

For example, if the user detects the health of the present battery 30 with 12 V/1000 CCA, the user may select 1/2 CCA to detect the battery 30 by the input device 11. Therefore, the microprocessor 20 of the battery tester obtains detection requirements: $CCA_B$=1000 CCA, $V_B$=12V, 1/N CCA=1/2 CCA, so a proper loading resistance is calculated by the equation of loading resistance and the resistance will be 0.024 ohm. The microprocessor 20 controls the variable resistor 21a to adjust the resistance of the variable resistor 21a to be 0.024 ohm. When the detecting wires 12 arecused to clip to the electrodes 31 of the battery 30, the variable resistor 21a with 0.024 ohm is added to the battery 30.

In another example, if the user detects the health of the present battery 30 with 12 V/900 CCA, the user may select 1/3 CCA to detect the battery 30 by the input device 11. Therefore, the microprocessor 20 of the battery tester obtains detection requirements:

$CCA_B$=900 CCA, $V_B$=12V, 1/N CCA=1/3 CCA, so a proper loading resistance is calculated by the equation of loading resistance and the resistance will be 0.04 ohm. The microprocessor 20 controls the variable resistor 21a to adjust the resistance of the variable resistor to be 0.04 ohm. When the detecting wires 12 clip to the electrodes of the battery 30, the variable resistor with 0.04 ohm is added to the battery 30.

Based on the above two examples, the resistance of the variable resistor can be changed according to the different capacities of the batteries.

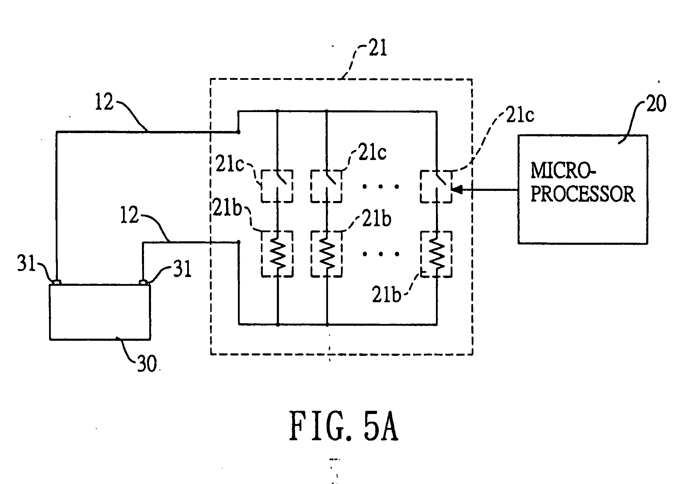

With further reference to Fig. 5A, another embodiment of the variable loading unit 21 has multiple resistors 21b and switching elements 21c. First ends of the resistors 21b are electronically connected to the detecting wires 12 and second ends of the resistors 21 b are respectively and electronically connected to the other detecting wire 12 through the corresponding switching elements 21c. The switching elements 21 c are electronically connected to the microprocessor 20. The microprocessor 20 drives each switching element 21c to be turned on or turned off to determine which one resistor 21b is connected to the two electrodes 31 of the battery 30, or which resistors 21b are electronically and parallelly connected to the two electrodes 31 of the battery 30. When a proper loading resistance is determined by the microprocessor 20, the microprocessor 20 drives one or more switching elements 21 c to be turned on according to the loading resistance. If two or more switching elements 21c are driven to be turned on at the same time, the resistance of the variable loading unit is smaller than that of one of the resistors 21b.

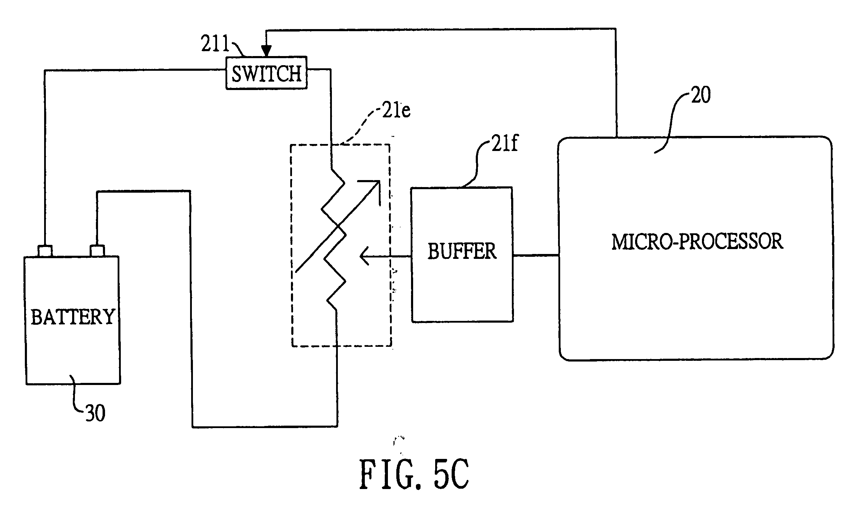

With reference to Fig. 5C, another embodiment of the variable loading unit has a programmable variable resistor 21e and a switch 211. The programmable variable resistor 21e is electronically connected to the detecting wires 12. A controlling end of the program variable resistor 21e is connected to the microprocessor 20. The microprocessor 20 directly adjusts the resistance of the programmable variable resistor 21e and drives the switch 211 to be turned on or off to determine whether the programmable variable resistor 21e is connected to the battery 30 or not. In addition, the microprocessor 20 is connected to the controlling end of the programmable variable resistor 21 e through a buffer 21f.

For example, if the resistors 21b have the same resistance as in Fig. 5A, and the resistance is 0.08ohm, one battery with 12V/750CCA is detected by the battery tester as shown in Fig. 5A. The user uses the input device 11 to select the 1/2CCA and 15sec loading time to enter the testing process.

Since the resistors 21b have the same resistance, the loading of the battery is 0.08ohm when the microprocessor 20 drives one of the switches 21c to be turned on. The microprocessor 20 has a power status detecting unit 22 to detect a present current value of the battery 30 with 0.08ohm. When the current value is equal to 100A, the microprocessor 20 calculates a proper loading resistance and the calculating process has the following steps of:

(a) calculating the numbers of the resistors with 0.08ohm; wherein [750*(1/2)/]/100=3.75; and
(b) calculating a total detecting power by 1/2 CCA and 15 sec, wherein the total detecting power is [750* (1/2)]* 15=5625(A-sec).

Since the microprocessor 20 just selects 3 resistors 21b to parallelly connect to the battery 30, the initial detection requirements input by the user are changed. A new loading time is changed to 18.75sec as calculated by an equation: 5625/300=18.75 sec.

In this example, the microprocessor 20 turns on 3 switches 21c, and the 3 resistors 21b are electronically and parallelly connected to the battery 30 for 18.75 sec.

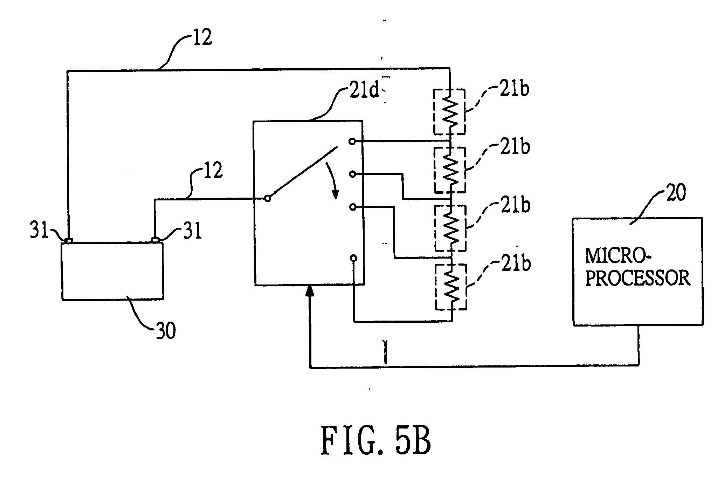

With further reference to Fig. 5B, another embodiment of the variable loading unit has multiple resistors 21 b connected in serial and a 1 to X multiplexer 21d having one common terminal COM and X switching terminals $S_1$ to $S_x$. X is the number of the resistors 21b. One end A of the series of the resistors is connected to one detecting wire 12 and the other detecting wire 12 is connected to the common terminal COM of the multiplexer 21 d. The switching terminals $S_1$ to $S_x$ of the multiplexer 21 d are respectively connected to serial nodes of the series of the resistors 21b and the other end B of the series of the resistors 21b. The microprocessor 20 drives the common terminal COM to connect to one of the switching terminals $S_1$ to $S_x$ to determine a resistance of the variable loading unit.

For example, the resistors 21b have the same resistance (0.08ohm) and a battery with 12V/1000CCA is detected. The user selects 1/2 CCA and 15sec loading time to detect the health of the battery 30.

Since the variable loading unit has multiple resistors 21b, one resistor 21b is first connected to the battery 30 by driving the multiplexer 21d and detects whether a present current value achieves 12/0.08=150A. If the current value achieves 150A, the microprocessor 20 further calculates a proper loading for the present battery 30. The calculating process has the following steps of:

(a)

$$1000/2*15=7500(A\text{-}sec);$$

and
(b)

$$75000/150=50(sec).$$

When the microprocessor 20 executes the loading process, the microprocessor 20 drives multiplexer 21d and the common terminal COM is connected to a first switching terminal $S_1$. One resistor 21b is selected to connect to the battery 30 through the detecting wires 12. In addition, the initial loading time (15sec) is changed to 50sec as a new loading time.

For another example, to detect another battery 30 with 12V/100CCA, the microprocessor 20 drives the multiplexer 21d and selects 3 resistors 21 b to connect to the battery 30 to detect the present current value (12V/ 0.24=50A). According to the present current value, the microprocessor 20 calculates a proper loading resistance. The calculating method has the following steps of:

(a)

$$100/2*15=750(A);$$

and

(b)

$$750/50=15 \ (sec),$$

wherein the final loading time is equal to the initial loading time selected by the user: the loading time is not changed.

When the microprocessor 20 executes the loading process, the microprocessor 20 drives multiplexer 21 d, and the common terminal COM is connected to a third switching terminal S3. The series of the three resistors 21b is selected to connect to the battery 30 through the detecting wires 12 to detect aging of the battery 30.

Based on the foregoing description, the variable loading unit 21 has multiple resistors 21b but the microprocessor 20 executes the strategic decision process to adjust the numbers of the resistors 21b and changes the initial loading time selected by the user. Therefore, the microprocessor 20 still obtains accuracy, detecting for the battery 30 with different capacities.

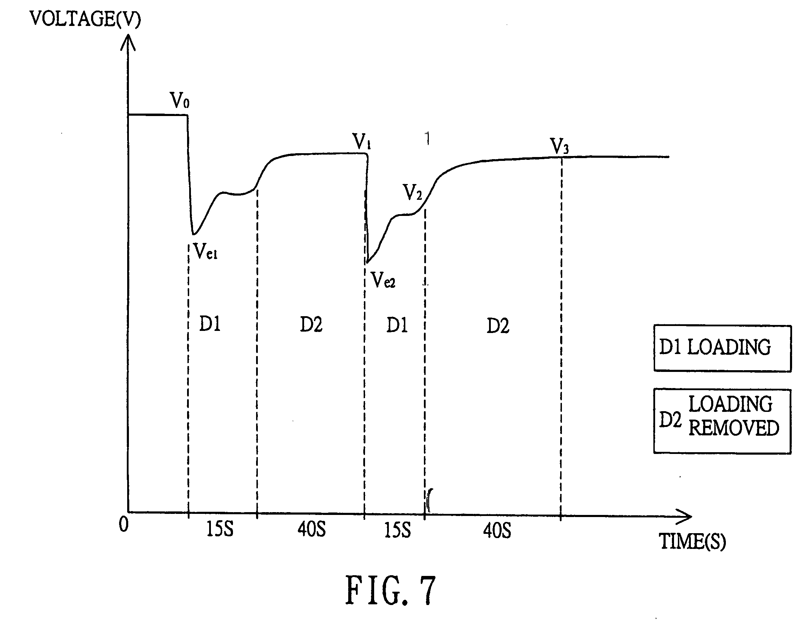

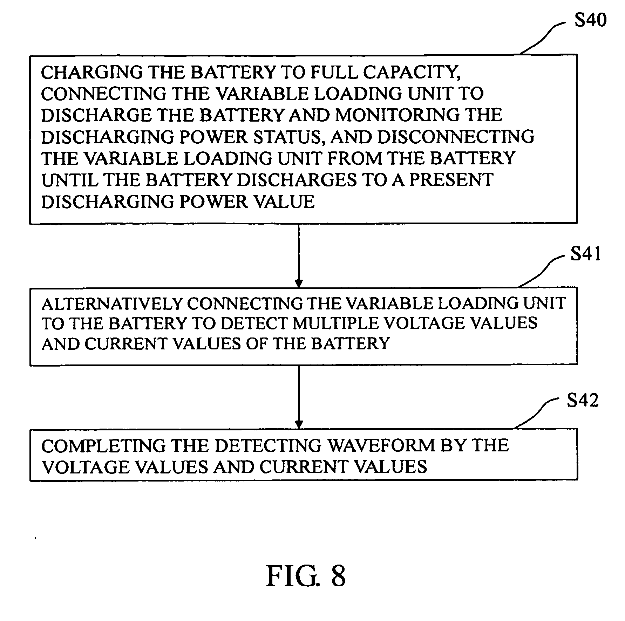

With reference to Figs. 1, 7 and 8, the detecting waveform obtained by the microprocessor 20 and the flow chart of the detecting process are shown. In detecting process, the battery 30 is first charged to full capacity and just removed from a charger. The variable loading unit 21 is then connected to the battery 30. The microprocessor 20 detects a discharging power of the battery 30 through the variable loading unit 21 and monitors whether a discharging power of the battery 30 achieves a present power vale ($V_{e2}$). When the discharging power achieves the present power value, the switches 21C are removed from the battery so the variable loading unit 21 is disconnected from the battery (S40). Therefore, the battery 30 has no surface charge voltage. Then, the variable loading unit 21 is alternatively connected to the battery 30 to detect multiple voltage values and current values of the battery 30 (S41). Finally, the detecting waveform is completed by the voltage values and/or current values and the microprocessor determines the health of the battery according to the detecting waveform (S42).

Even though numerous characteristics and advantages of the present invention have been set forth in the foregoing description, together with details of the structure and function of the invention, the disclosure is illustrative only. Changes may be made in detail, especially in matters of shape, size, and arrangement of parts within the principles of the invention to the full extent indicated by the broad general meaning of the terms in which the appended claims are expressed.

## Claims

1. A battery tester, comprising a casing (10) having an input device (11) and two detecting wires (12), a microprocessor (20), a variable loading unit (21) and a battery power status detecting unit (22), wherein:

   the detecting wires (12) are adapted to selectively connect to two electrodes (31) of a battery (30);
   the variable loading unit (21) is electronically connected to the microprocessor (20) and connected to the detecting wires (12); and
   the battery power status detecting unit (22) is electronically connected to the microprocessor (20) to detect a battery voltage ($V_B$) and a battery current ($I_B$) of the battery (30) and to report the battery voltage ($V_B$) and battery current ($I_B$) to the microprocessor (20); **characterized in**:

   the input device (11) providing different options of cold cranking amperes ($CCA_B$) and detection requirements including a 1/N CCA; and
   the microprocessor (20) storing a strategic decision process and being adapted to execute the following steps of this process:

   (a) obtaining an initial battery voltage ($V_B$) of a present battery (30) and reading the cold cranking amperes ($CCA_B$) and the 1/N CCA from the input device 11 (S 10);
   (b) calculating an equation of loading resistance with the cold cranking amperes ($CCA_B$), the initial battery voltage ($V_B$) and the 1/N CCA to obtain a proper loading resistance for the battery (30), and adjusting a resistance of the variable loading unit (21) in accordance with the calculated loading resistance (S11); wherein the equation is:

   $$\frac{V_B}{CCA_B \times {}^1\!/\!_N}\ j\ \text{and}$$

   (c) executing a detecting process to obtain a detecting waveform (S12).

2. The battery tester as claimed in claim 1, wherein the variable loading unit (21) is a variable resistor (21a) having:

   two ends respectively connected to the detecting wires (12); and
   one controlling end electronically connected to the microprocessor 20, wherein the microprocessor (20) is adapted to adjust the resistance of the variable resistor (21a).

3. The battery tester as claimed in claim 1, wherein the variable loading unit (21) has multiple resistors (21b) and multiple switches (21c) electronically connected to the microprocessor (20), wherein one end of each resistor (21 b) is connected to one of the detecting wires (12), and the other ends of the resistors (21 b) are respectively connected to the other detecting wire (12) through the switches (2 1 c).

4. The battery tester as claimed in claim 1, wherein the variable loading unit (21) has:

   multiple resistors (21b) connected in serial to be a series of the resistors, wherein one end of the series of the resistors (21 b) is connected to one of the detecting wires (12); and
   a multiplexer (21d) having:

   a common terminal connected to the other detecting wire (12);
   multiple switching terminals respectively connected to serial nodes of the series of the resistors (21b) and the other end of the series of the resistors (21b); and
   a controlling terminal electronically connected to the microprocessor (20), wherein the microprocessor (20) is adapted to drive the multiplexer (21d) to determine which one of the switching terminals is connected to the common terminal.

5. The battery tester as claimed in claim 1, wherein the variable loading unit (21) has:

   a programmable variable resistor (21e) having a controlling end electronically connected to the microprocessor (20); and

a switch (211) connected between the programmable variable resistor (21e) and the detecting wire (12), and electronically connected to the microprocessor (20).

6. The battery tester as claimed in claim 1, wherein the variable loading unit has:

a programmable variable resistor (21e) having:

two ends respectively connected to the detecting wires (12); and
a controlling end electronically connected to the microprocessor (20);

a buffer 21f electronically connected between the microprocessor (20) and controlling end of the programmable variable resistor (21e); and
a switch (211) connected between one end of the programmable variable resistor (21e), and the detecting wire (12) and electronically connected to the microprocessor (20).

7. The battery tester as claimed in claim 1, wherein the detecting process has steps of:

(a) charging the battery to full capacity and then just removed from a charger (S40);
(b) connecting the variable loading (21) unit to discharge the battery (30) and monitoring the discharging power status (S40);
(c) disconnecting the variable loading unit (21) from the battery (30) until the battery (30) discharges to a power threshold_(S40);
(d) alternatively connecting the variable loading unit (21) to the battery (30) to detect multiple voltage values and current values of the battery (30) (S41); and
(e) completing the detecting waveform by the voltage values and current values (S42).

8. The battery tester as claimed in claim 1, wherein the casing further comprises a display (13), a computer connector (14) and an alarm (15).

**Patentansprüche**

1. Batterietestgerät, umfassend ein Gehäuse (10) mit einer Eingabevorrichtung (11) und zwei Ermittlungsdrähten (12), einen Mikroprozessor (20), eine veränderbare Belastungseinheit (21) und eine Einheit (22) zur Ermittlung des Batterieleistungszustandes, wobei

die Ermittlungsdrähte (12) wahlweise mit zwei Elektroden (31) einer Batterie (30) verbindbar sind;
die veränderbare Belastungseinheit (21) elektronisch mit dem Mikroprozessor (20) verbunden ist und mit den Ermittlungsdrähten (12) verbunden ist; und

die Einheit (22) zur Ermittlung des Batterieleistungszustandes mit dem Mikroprozessor (20) elektronisch verbunden ist, um eine Batteriespannung ($V_B$) und einen Batteriestrom ($I_B$) der Batterie (30) zu ermitteln und die Batteriespannung ($V_B$) und den Batteriestrom ($I_B$) dem Mikroprozessor (20) mitzuteilen; **dadurch gekennzeichnet dass**

die Eingabevorrichtung (11) verschiedene Optionen von Kaltstart-Stromstärken ($CCA_B$) und Ermittlungsanforderungen beinhaltend ein 1/N CCA bereitstellt; und

der Mikroprozessor (20) einen strategischen Entscheidungsprozess speichert und dazu angepasst ist, die folgenden Schritte dieses Prozesses durchzuführen:

(a) Erhalten einer anfänglichen Batteriespannung ($V_B$) einer vorliegenden Batterie (30) und Auslesen der Kaltstart-Stromstärken ($CCA_B$) und der 1/N CCA aus der Eingabevorrichtung 11 (S 10);
(b) Berechnen einer Gleichung des Belastungswiderstandes mit der Kaltstart-Stromstärke ($CCA_B$), der anfänglichen Batteriespannung ($V_B$) und der 1/N CCA, um einen eigenen Belastungswiderstand für die Batterie (30) zu erhalten und einen Widerstand der veränderbare Belastungseinheit (21) in Übereinstimmung mit dem berechneten Belastungswiderstand (S11) einzustellen; wobei die Gleichung

$$\frac{V_B}{CCA_B \times \frac{1}{N}},$$ ist, und

(c) Ausführen eines Ermittlungsvorgangs, um eine Ermittlungs-Wellenform (S 12) zu erhalten.

2. Batterietestgerät gemäß Anspruch 1, wobei die veränderbare Belastungseinheit (21) ein veränderbarer Widerstand (21 a) ist mit

zwei jeweils mit den Ermittlungsdrähten (12) verbundenen Enden; und

einem elektronisch mit dem Mikroprozessor (20) verbundenen Steuerende, wobei der Mikroprozessor (20) dazu angepasst ist, den Widerstand des veränderbaren Widerstandes (21 a) einzustellen.

3. Batterietestgerät gemäß Anspruch 1, wobei die veränderbare Belastungseinheit (21) mehrere Widerstände (21b) und mehrere Schalter (21c) aufweist, die elektronisch mit dem Mikroprozessor (20) verbunden sind, wobei ein Ende von jedem Widerstand (21b) mit einem der Ermittlungsdrähte (12) verbunden ist, und die anderen Enden der Widerstände (21b) durch die Schalter (21 c) mit dem anderen Ermittlungsdraht (12) verbunden sind.

**4.** Batterietestgerät gemäß Anspruch 1, wobei die veränderbare Belastungseinheit (21) aufweist:

mehrere Widerstände (21b), in Reihe verbunden um eine Reihe der Widerstände zu bilden, wobei ein Ende der Reihe der Widerstände (21b) mit einem der Ermittlungsdrähte (12) verbunden ist; und
einen Multiplexer (21 d) mit
einem gemeinsamen Anschlusspunkt, der mit dem anderen Ermittlungsdraht (12) verbunden ist;
mehreren Schaltanschlusspunkten, die jeweils mit Reihenknoten der Reihe von Widerständen (21b) und dem anderen Ende der Reihe von Widerständen (21b) verbunden sind; und
einem Steueranschlusspunkt, elektronisch verbunden mit dem Mikroprozessor (20), wobei der Mikroprozessor (20) dazu ausgebildet ist, den Multiplexer anzusteuern, um zu ermitteln, welcher der Schaltanschlusspunkte mit dem gemeinsamen Anschlusspunkt verbunden ist.

**5.** Batterietestgerät gemäß Anspruch 1, wobei die veränderbare Belastungseinheit (21) aufweist:

einen programmierbaren veränderbaren Widerstand (21 e) mit einem Steuerende, das elektronisch mit dem Mikroprozessor (20) verbunden ist; und
einen Schalter (211), angeschlossen zwischen dem programmierbaren veränderbaren Widerstand (21e) und dem Ermittlungsdraht (12), und elektronisch mit dem Mikroprozessor (20) verbunden.

**6.** Batterietestgerät gemäß Anspruch 1, wobei die veränderbare Belastungseinheit (21) aufweist:

einen programmierbaren veränderbaren Widerstand (21e) mit:

zwei jeweils mit den Ermittlungsdrähten (12) verbundenen Enden; und
einem Steuerende, das elektronisch mit dem Mikroprozessor (20) verbunden ist;
einem Puffer 21f, der elektronisch zwischen dem Mikroprozessor (20) und dem Steuerende des programmierbaren veränderbaren Widerstandes (21e) verbunden ist; und
einem Schalter (211), verbunden zwischen einem Ende des programmierbaren veränderbaren Widerstandes (21e) und dem Ermittlungsdraht (12) und elektronisch mit dem Mikroprozessor (20) verbunden.

**7.** Batterietestgerät gemäß Anspruch 1, wobei der Ermittlungsvorgang die Schritte aufweist von:

(a) Aufladen der Batterie zu voller Kapazität und dann sofort von einem Ladegerät (S40) entfernen;
(b) Anschließen der veränderbaren Belastungseinheit (21), um die Batterie (30) zu entladen, und dann Kontrollieren des Entladungsleistungszustandes (S40),
(c) Trennen der veränderbaren Belastungseinheit (21) von der Batterie (30), bis die Batterie auf einen Leistungsschwellwert (S40) entlädt;
(d) alternativ Verbinden der veränderbaren Belastungseinheit (21) mit der Batterie (30), um mehrere Spannungswerte und Stromwerte der Batterie (30) (S41) zu ermitteln; und
(e) Vervollständigen der Ermittlungs-Wellenform mit den Spannungswerten und Stromwerten (S42).

**8.** Batterietestgerät gemäß Anspruch 1, wobei das Gehäuse ferner eine Anzeigevorrichtung (13), einen Computeranschluss (14) und eine Alarmeinrichtung (15) aufweist.

## Revendications

**1.** Testeur de batterie, comportant un boîtier (10) avec un dispositif d'entrée (11) et deux fils de détection (12), un microprocesseur (20), une unité de mise en charge électrique variable (21) et une unité (22) de détection de la condition de puissance de batterie, dans lequel
les fils de détection (12) se laissent raccorder à deux électrodes (31) d'une batterie (30) à choix;
l'unité de mise en charge électrique variable (21) est électroniquement raccordée au microprocesseur (20) et raccordée aux fils de détection (12); et
l'unité (22) de détection de la condition de puissance de batterie est électroniquement raccordée au microprocesseur (20), pour détecter une tension de batterie ($V_B$) et un courant de batterie ($I_B$) de la batterie (30), et de rapporter la tension de batterie ($V_B$) et le courant de batterie ($I_B$) au microprocesseur (20);
**caractérisé en ce que**
le dispositif d'entrée (11) fournit des options différentes de courants de démarrage à froid (CCAB) et des exigences de détection y enclos un 1/N CCA; et le microprocesseur (20) mémorise un procès de décision stratégique et est adapté à exécuter les étapes suivantes dudit procès:

(a) obtenir une tension de batterie ($V_B$) initiale d'une batterie (30) présente et lire les courants de démarrage à froid (CCAB) et 1/N CCA à partir du dispositif d'entrée 11 (S10);

(b) calculer une équation de la résistance de mise en charge avec le courant de démarrage à froid (CCAB), la tension de batterie ($V_B$) initiale et 1/N CCA, pour obtenir une propre résistance de mise en charge pour la batterie (30) et pour ajuster la résistance de l'unité de mise en charge électrique variable (21) conformément à la résistance de mise en charge (S11) calculée,

l'équation étant $\dfrac{V_B}{CCA_B \times 1/N}$, et

(c) exécuter un procès de détection pour obtenir une forme de l'onde de détection (S 12).

2. Testeur de batterie selon la revendication 1, dans lequel l'unité de mise en charge électrique variable (21) est une résistance variable (21a) avec deux extrémités, chacune raccordée aux fils de détection (12); et une extrémité de commande, électroniquement raccordée au microprocesseur (20), le microprocesseur (20) étant adapté pour ajuster la résistance de la résistance variable (21a).

3. Testeur de batterie selon la revendication 1, dans lequel l'unité de mise en charge électrique variable (21) a plusieurs résistances (21b) et plusieurs interrupteurs (21c), qui sont électroniquement raccordés au microprocesseur (20), une extrémité de chaque résistance (21b) étant raccordée à un des fils de détection (12), et les autres extrémités des résistances (21 b) étant raccordés à l'autre fil de détection (12) à travers les interrupteurs (21 c).

4. Testeur de batterie selon la revendication 1, dans lequel l'unité de mise en charge électrique variable (21) a:

plusieurs résistances (21 b), raccordées en série pour former une série des résistances, une extrémité de la série des résistances (21b) étant raccordé à un des fils de détection (12); et un multiplexeur (21d) avec une tête de raccordement commune, qui est raccordée à l'autre fil de détection (12) ; plusieurs raccordements de commutation, chacun raccordé à des noeuds de série de la série de résistances (21b) et à l'autre extrémité de la série de résistances (21b); et un raccordement de commande, électroniquement raccordé au microprocesseur (20), le microprocesseur (20) étant adapté pour commander le multiplexeur, afin de détecter quel raccordement de commutation est raccordé à la tête de raccordement commune.

5. Testeur de batterie selon la revendication 1, dans lequel l'unité de mise en charge électrique variable (21) a:

une résistance variable programmable (21 e) avec une extrémité de commande, qui est électroniquement raccordée au microprocesseur (20); et un interrupteur (211), raccordé entre la résistance variable programmable (21e) et le fil de détection (12), et électroniquement raccordé au microprocesseur (20).

6. Testeur de batterie selon la revendication 1, dans lequel l'unité de mise en charge électrique variable (21) a:

une résistance variable programmable (21 e) avec:

deux extrémités, chacune raccordée aux fils de détection (12) respectives; et une extrémité de commande, électroniquement raccordée au microprocesseur (20); un tampon 21f, raccordé électroniquement entre le microprocesseur (20) et l'extrémité de commande de la résistance variable (21e) programmable; et un interrupteur (211), raccordé entre une extrémité de la résistance variable (21 e) programmable et le fil de détection (12), et électroniquement raccordé au microprocesseur (20).

7. Testeur de batterie selon la revendication 1, dans lequel le procès de détection a les étapes de:

(a) charger la batterie jusqu à la capacité complète, et puis immédiatement la séparer du dispositif de recharge (S40); (b) raccorder l'unité de mise en charge électrique variable (21), pour décharger la batterie (30), et surveiller la condition de la puissance de déchargement (S40), (c) séparer l'unité de mise en charge électrique variable (21) de la batterie (30), jusqu'à ce que la batterie se décharge à un seuil de puissance (S40); (d) alternativement, raccorder l'unité de mise en charge électrique (21) variable à la batterie (30) pour détecter plusieurs valeurs de tension et valeurs de courant de la batterie (30) (S41); et (e) compléter la forme de l'onde de détection avec les valeurs de tension et les valeurs de courant (S42).

8. Testeur de batterie selon la revendication 1, dans lequel le boîtier comporte en outre un dispositif d'affichage (13), un connecteur d'ordinateur (14) et un
dispositif d'alarme (15).

FIG.1

FIG. 2

EP 2 506 024 B1

OBTAINING CCA_B INPUTTED FROM THE INPUT DEVICE, THE BATTERY VOLTAGE (V_B) OF A PRESENT BATTERY FROM THE BATTERY POWER STATUS UNIT, AND A 1/N CCA AND A LOADING TIME INPUTTED FROM THE INPUT DEVICE ⟶ S10

CALCULATING AN EQUATION OF LOADING RESISTANCE WITH THE BATTERY CAPACITY, THE INITIAL VOLTAGE AND THE DETECTION REQUIREMENTS TO OBTAIN A PROPER LOADING RESISTANCE FOR THE PRESENT BATTERY, WHEREIN THE EQUATION IS $\dfrac{V_B}{CCA_B \times \frac{1}{N}}$ , AND ADJUSTING A RESISTANCE OF THE VARIABLE LOADING UNIT IN ACCORDANCE WITH THE CALCULATED LOADING RESISTANCE ⟶ S11

EXECUTING A DETECTING PROCESS TO OBTAIN A DETECTING WAVEFORM ⟶ S12

# FIG. 3

EP 2 506 024 B1

FIG. 4

FIG. 5A

FIG. 5B

FIG. 5C

EP 2 506 024 B1

OBTAINING THE CAPACITY (CCAB), THE VOLTAGE (VB) AND THE DETECTING REQUIREMENTS HAVING 1/N CCA AND LOADING TIME — S20

ADDING AT LEAST ONE RESISTOR TO CONNECT TO THE BATTERY BY DRIVING THE MULTIPLEXER TO CONNECT THE COMMON TERMINAL TO ONE OF THE SWITCHING TERMINAL TO DETECT A PROPER CURRENT VALUE — S21

CALCULATING THE RESISTANCE OF THE VARIABLE LOADING UNIT ACCORDING TO THE CURRENT VALUE — S22

CALCULATING THE EQUATION OF CALCULATING TOTAL DETECTING TIME WITH INITIAL TESTING INFORMATION INCLUDING 1/N CCA AND LOADING TIME — S23

CHANGING THE INITIAL LOADING TIME ACCORDING TO NUMBERS OF THE RESISTORS SELECTED BY MICROPROCESSOR — S24

EXECUTING THE DETECTING PROCESS TO OBTAIN A DETECTING CURVE — S25

# FIG. 6

FIG. 7

EP 2 506 024 B1

S40

CHARGING THE BATTERY TO FULL CAPACITY,
CONNECTING THE VARIABLE LOADING UNIT TO
DISCHARGE THE BATTERY AND MONITORING THE
DISCHARGING POWER STATUS, AND DISCONNECTING
THE VARIABLE LOADING UNIT FROM THE BATTERY
UNTIL THE BATTERY DISCHARGES TO A PRESENT
DISCHARGING POWER VALUE

S41

ALTERNATIVELY CONNECTING THE VARIABLE LOADING UNIT
TO THE BATTERY TO DETECT MULTIPLE VOLTAGE VALUES
AND CURRENT VALUES OF THE BATTERY

S42

COMPLETING THE DETECTING WAVEFORM BY THE
VOLTAGE VALUES AND CURRENT VALUES

FIG. 8

**EP 2 506 024 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006244423 A1
- US 6369577 B1
- US 4707795 B1
- US 2009237086 A1
- US 5773977 A
- US 6259254 B1